# EUROPÄISCHE PATENTSCHRIFT

(11) **EP 1 335 474 B1**
(45) Veröffentlichungstag und Bekanntmachung des Hinweises auf die Patenterteilung: **16.12.2009**
(21) Anmeldenummer: 02025216.9
(22) Anmeldetag: 12.11.2002
(51) Int. Cl.: H02J 7/00

(54) **Vorrichtung zum Schützen der elektrischen und elektronischen Bauteile eines Kraftfahrzeugs vor Überspannungen**
Device for protection of electric and electronic components of a vehicle from overvoltages
Dispositif pour protéger les composants éléctriques et éléctroniques d'un véhicule contre les surtensions

(30) Priorität: 15.11.2001 DE 20118664 U
(43) Veröffentlichungstag der Anmeldung: 13.08.2003
(73) Patentinhaber: Rüttgerodt, Werner, 34355 Staufenberg (DE)
(72) Erfinder: Rüttgerodt, Werner, 34355 Staufenberg (DE)
(74) Vertreter: Rehberg Hüppe + Partner

(56) Entgegenhaltungen:
- DE-A1- 3 722 286
- DE-A1- 19 616 542
- DE-A1- 19 649 392
- US-A- 5 343 135

## Beschreibung

Die Erfindung bezieht sich auf eine Vorrichtung zum Schützen der elektrischen und elektronischen Bauteile eines Kraftfahrzeugs vor Überspannungen, mit zwei Kontaktelementen zur lösbaren Kontaktierung der beiden Pole einer Spannungsversorgung des Kraftfahrzeugs und mit einer zwischen die beiden Kontaktelemente geschalteten elektrischen Schaltung, wobei die elektrische Schaltung ein Anzeigeelement zum Anzeigen des Anliegens einer Spannung zwischen den beiden Kontaktelementen und ein Überspannungsschutzelement zum Abbauen von auftretenden und über einem Schwellwert liegenden Überspannungen aufweist.

Moderne Kraftfahrzeuge weisen in zunehmendem Maße elektronische aber auch elektrische Bauteile auf, die empfindlich auf Überspannungen in der Spannungsversorgung des jeweiligen Kraftfahrzeugs reagieren. Gleichzeitig sind beispielsweise beim elektrischen Schweißen an einer Kraftfahrzeugkarosserie elektrische Spannungen, die sich auf die Spannungsversorgung des Kraftfahrzeugs auswirken können, kaum vermeidbar. Als Gegenmaßnahme ist das Abklemmen der Batterie des jeweiligen Kraftfahrzeugs bekannt, was aber mit dem Nachteil verbunden ist, dass hierdurch die Speicher verschiedener elektronischer Bauteile des Kraftfahrzeugs gelöscht werden.

Als Alternative zum Ausbauen der Batterie ist es bekannt, die beiden Pole der Spannungsversorgung des Kraftfahrzeugs, d.h. beispielsweise die beiden Pole einer Batterie, durch ein sogenanntes Überspannungsschutzkabel miteinander zu verbinden. In dem Überspannungsschutzkabel ist eine elektrische Schaltung vorgesehen, die ein Überspannungsschutzelement zum Abbauen von auftretenden und über einem Schwellwert liegenden Überspannungen aufweist, um die elektrischen und elektronischen Bauteile eines Kraftfahrzeugs beispielsweise beim elektrischen Schweißen an seiner Karosserie zu schützen. Nachteil dieses bekannten Überspannungsschutzkabels ist, dass es über keinerlei Anzeigen verfügt, die seine Funktion dokumentieren.

Überspannungen, die die elektrischen und elektronischen Bauteile eines Kraftfahrzeugs schädigen können, können auch bei der sogenannten Starthilfe auftreten, bei der die Spannungsversorgung eines Kraftfahrzeugs mit einer externen Spannungsquelle, insbesondere mit der Spannungsversorgung eines anderen Kraftfahrzeugs verbunden wird. Um hier Abhilfe zu schaffen, ist aus der DE 37 22 286 C2 bekannt, zwischen den beiden Leitungskabeln einer Vorrichtung zur Starthilfe eine elektrische Schaltung mit einem Überspannungsschutzelement zum Abbauen von auftretenden und über einem Schwellwert liegenden Überspannungen anzuordnen. Auch bei dieser bekannten Vorrichtung sind keine Anzeigeelemente vorhanden, die die Funktion der Vorrichtung dokumentieren.

Aus der DE 196 49 392 C2 ist eine Vorrichtung zur Spannungserhaltung bei Kraftfahrzeugen durch eine externe Stromquelle bei ausgebauter bzw. abgeklemmter Batterie bekannt, bei der zwischen zwei Kontaktelementen zum Anschluss an die beiden Pole der Spannungsversorgung des Kraftfahrzeugs einerseits ein Überspannungsschutzelement zum Abbauen von auftretenden und über einem Schwellwert liegenden Überspannung und andererseits eine Leuchtdiode vorgesehen ist, die leuchtet, wenn die Kontaktelemente korrekt an die Pole der Spannungsversorgung des Kraftfahrzeugs angeschlossen sind. Daneben gibt es weitere Leuchtdioden, die anzeigen, ob zwei weitere Kontaktelemente korrekt an eine externe Spannungsquelle angeschlossen sind und dass, nachdem alle Anschlüsse korrekt hergestellt sind, die beiden Stromkreise der Spannungsversorgung des Kraftfahrzeugs und der externen Stromquelle miteinander verbunden sind. Die aus der DE 196 49 392 C2 bekannte Vorrichtung umfasst damit eine Vorrichtung der eingangs beschriebenen Art. Obwohl bereits gewisse Funktionen dieser Vorrichtung dem Benutzer angezeigt werden, erkennt er beispielsweise nicht, ob Überspannungen tatsächlich aufgetreten bzw. aufgetreten sind. Dies wäre jedoch wichtig zu erfahren, um beispielsweise auftretende Störungen in der Kraftfahrzeugelektrik diesen Überspannungen zuordnen zu können.

Der Erfindung liegt daher die Aufgabe zugrunde, eine Vorrichtung der eingangs beschriebenen Art aufzuzeigen, die ihre Funktion dem Benutzer weitergehend dokumentiert.

Diese Aufgabe wird erfindungsgemäß dadurch gelöst, dass bei einer Vorrichtung der eingangs beschriebenen Art die elektrische Schaltung weiterhin ein Anzeigeelement zum Anzeigen von auftretenden und über einem Schwellwert liegenden Überspannungen aufweist.

Die neue Vorrichtung zeigt nicht nur an, dass sie sich grundsätzlich in Funktion befindet. Sie zeigt auch an, wenn Überspannungen auftreten, die von der Vorrichtung abgebaut werden. So kann der Benutzer je nach Verwendung der Vorrichtung seine sonstige Arbeitsweise dahingehend optimieren, dass möglichst wenig Überspannungen aufgebaut werden. Oder er wird zumindest in die Lage versetzt, später auftretende Störungen der Kraftfahrzeugelektrik einer aufgetretenen Überspannung zuzuordnen oder gerade nicht. Bei der neuen Vorrichtung kann der Schwellwert, bei dessen Überschreiten eine Überspannung mit dem weiteren Anzeigeelement angezeigt wird, gleich dem Schwellwert sein, ab dem Überspannungen abgebaut werden. Dies ist aber nicht zwingend der Fall. Der Schwellwert für die Anzeige von Überspannungen kann beispielsweise auch niedriger liegen, als derjenige, ab dem Überspannungen abgebaut werden. Wie die Schwellwerte zueinander liegen, wird von dem Aufbau der elektronischen Schaltung im Einzelfall abhängen. Hier sind dem Fachmann verschiedene Möglichkeiten gegeben. Er kann beispielsweise auf die Detailausführungen in dem oben zitierten Stand der Technik zurückgreifen.

Das Anzeigeelement der neuen Vorrichtung, das anzeigt, ob überhaupt eine Spannung zwischen den beiden Kontaktelementen anliegt und damit die grundsätzliche Funktion der neuen Vorrichtung dokumentiert, ist vorzugsweise ein optisches Anzeigeelement. Bei dem Anzeigeelement zum Anzeigen von auftretenden und über dem Schwellwert liegenden Überspannungen kann es hingegen günstig sein, alternativ oder zusätzlich ein akustisches Anzeigeelement einzusetzen. Der Vorteil liegt darin, dass sich die neue Vorrichtung beispielsweise beim elektrischen Schweißen an der Karosserie nicht immer im Blickfeld des Benutzers befindet, der aber ein akustisches Signal hinreichender Lautstärke durchaus wahrnehmen kann.

Alternativ oder zusätzlich kann das Anzeigeelement zum Anzeigen von auftretenden und über dem Schwellwert liegenden Überspannungen so ausgebildet sein, dass es von einer Überspannung in einem Warnzustand überführt wird, in dem es auch nach dem Wiederabfallen der Spannung verbleibt, soweit es nicht zurückgesetzt wird. Dem Benutzer wird also angezeigt, ob während der Verwendung der Vorrichtung überhaupt eine über dem Schwellwert liegende Überspannung aufgetreten ist. Wenn er dies registriert hat, kann er das Anzeigeelement aus dem Warnzustand in seinen Grundzustand zurücksetzen. Dies kann beispielsweise auch automatisch erfolgen, wenn die Vorrichtung ganz von der Spannungsversorgung des jeweiligen Kraftfahrzeugs abgenommen wird, so dass keine äußeren Spannungen mehr anliegen.

Das Anzeigeelement zum Anzeigen von auftretenden und über einem Schwellwert liegenden Überspannungen kann statt der Tatsache der Überschreitung des Schwellwerts auch die Höhe der aktuellen Überspannung und/oder die Höhe der höchsten aufgetretenen Überspannung anzeigen. In dem letzteren Fall versteht es sich, dass es wie in der obigen Ausführungsform mit dem Warnzustand des Anzeigeelements irgendeine Möglichkeit zum Rücksetzten des Anzeigeelements geben muss. Die Höhe der Öberspannung kann als konkreter Wert analog oder digital angezeigt werden. Es ist aber auch eine relative Höhenanzeige beispielsweise durch eine ansteigende Frequenz bei einem akustischen Anzeigeelement oder durch ein zunehmend breites Leuchtband bei einem optischen Anzeigeelement möglich.

Die neue Vorrichtung kann grundsätzlich so ausgebildet sein, dass sie unabhängig von der Polung an ihren beiden Kontaktelementen arbeitet. Häufig ist es aber einfacher, wenn die neue Vorrichtung mit einer festen Polung arbeitet. Dann ist jedes Befestigungselement einem der Pole der Spannungsversorgung des Kraftfahrzeugs zugeordnet, und vorzugsweise zeigt das Anzeigeelement zum Anzeigen des Anliegens einer Spannung zwischen den beiden Kontaktelementen nur eine Spannung der richtigen Polung an.

Die neue Vorrichtung kann als reines Überspannungsschutzkabel beispielsweise für Schweißarbeiten an der Karosserie eines Kraftfahrzeugs vorgesehen sein. Sie kann aber auch als Starthilfekabel vorgesehen sein, indem auf jeder Seite der elektrischen Schaltung zwei durch ein Leitungskabel miteinander Kontaktelemente vorgesehen sind, die jeweils an das zu startende Fahrzeug einerseits und an ein Starthilfe gebendes Fahrzeug andererseits anzuschließen sind.

Die Erfindung wird im folgenden anhand von zwei Ausführungsbeispielen näher erläutert und beschrieben, dabei zeigt
- Fig. 1: eine schematische Ansicht einer ersten Ausführungsform der neuen Vorrichtung und
- Fig. 2: eine schematische Ansicht einer zweiten Ausführungsform der neuen Vorrichtung.

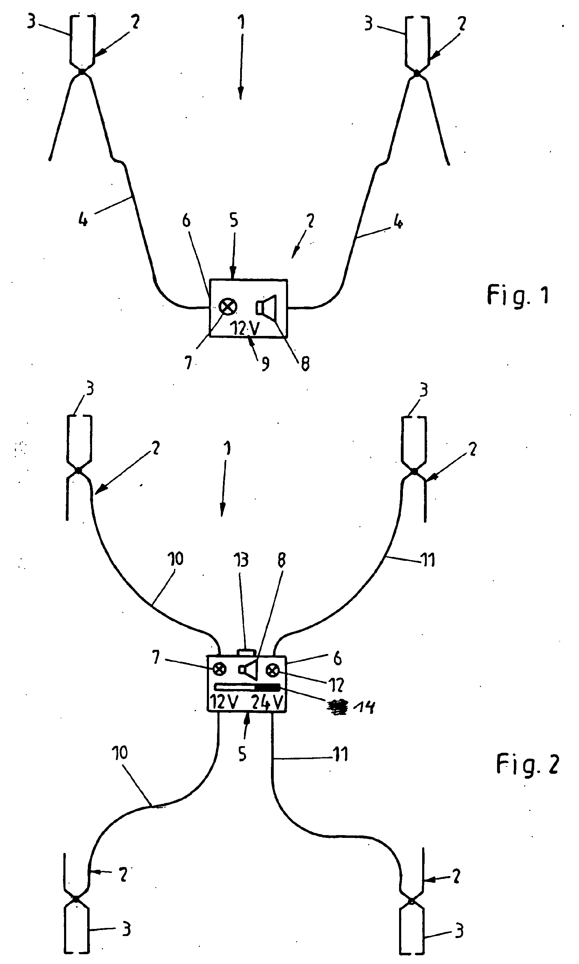

Die in Fig. 1 dargestellte Vorrichtung 1 weist zwei Kontaktzangen 2 als Kontaktelemente 3 auf. Die Kontaktelemente 3 sind jeweils über einen Kabelabschnitt 4 mit einer elektrischen Schaltung 5 in einem Gehäuse 6 verbunden. Die elektrische Schaltung 5 wird hier nicht in ihren Einzelheiten, d.h. nicht in Form eines Schaltplans, beschrieben, sondern nur anhand ihrer erbrachten Funktionen. Die Hauptaufgabe der elektrischen Schaltung 5 ist es, zwischen den beiden Kontaktelementen drei auftretende Überspannungen abzufangen, d.h. abzubauen. Wenn die beiden Kontaktelemente 3 an die beiden Pole einer Spannungsversorgung eines Kraftfahrzeugs, beispielsweise die beiden Pole einer Kraftfahrzeugbatterie, angeklemmt werden, verhindert die Schaltung 5 das Auftreten von Überspannungen zwischen den beiden Polen, auch wenn beispielsweise an der Karosserie des Kraftfahrzeugs elektrisch geschweißt wird. Um diese Funktion der Schaltung 5 der Vorrichtung 1 nach außen zu dokumentieren, weist die Schaltung 5 an dem Gehäuse 6 zwei Anzeigeelemente 7 und 8 auf. Ein erstes Anzeigeelement 7, bei dem es sich um ein optisches Anzeigeelement vorzugsweise in Form einer Leuchtdiode handelt, zeigt an, dass überhaupt eine Spannung zwischen den beiden Kontaktelementen 3 anliegt und dass diese Spannung die richtige Polung aufweist, damit die Schaltung 5 korrekt arbeiteten, d.h. Überspannungen zwischen den beiden Kontaktelementen 3 abfangen kann. Ein weiteres Anzeigeelement 8, bei dem es sich um ein akustisches Anzeigeelement handelt, was durch das Lautsprechersymbol angedeutet ist, zeigt das tatsächliche Auftreten von Überspannungen zwischen den Kontaktelementen 3 an, indem ein Warnton abgestrahlt wird. Der Warnton setzt beim Überschreiten eines Schwellwerts durch die Überspannungen ein. Dieser Schwellwert kann identisch mit einem Schwellwert sein, ab dem Überspannungen von der elektrischen Schaltung 5 auch tatsächlich vollständig abgebaut werden, wozu das Anzeigeelement 8 allein nicht in der Lage sein wird. Es macht aber Sinn, das akustische Anzeigeelemente 8 eher ansprechen zu lassen als ein Überspannungsschutzelement der elektrischen Schaltung 5. Außen an dem Gehäuse 6 ist weiterhin eine Angabe 9 der Spannung zu erkennen, für die die elektrische Schaltung 5 ausgelegt ist. D.h., es ist die Spannung angegeben, deren signifikante Überschreitung durch die Schaltung 5 verhindert wird. Für unterschiedliche Betriebsspannungen sind dann unterschiedlicher Ausführungen der Vorrichtung 1 zu verwenden.

Die in Fig. 2 dargestellte Ausführungsform der Vorrichtung 1 ist im Gegensatz zu derjenigen gemäß Fig. 1 kein reines Überspannungsschutzkabel sondern es handelt sich um ein Starthilfekabel. Hierzu gehören insgesamt vier von Anschlussklemmen 2 gebildete Kontaktelemente, die paarweise über jeweils ein Leitungskabel 10 bzw. 11 miteinander verbunden sind. In dem Gehäuse 6 ist zwischen die beiden Leitungskabel 10 und 11 die elektrische Schaltung 5 geschaltet. Die elektrische Schaltung 5 verhindert hier, dass beim Geben von Starthilfe Überspannungen in der Spannungsversorgung des Starthilfe gebenden und des Starthilfe empfangenen Kraftfahrzeugs auftreten, die die elektrischen und elektronischen Bauteile eines der Kraftfahrzeuge beschädigen könnten. Dabei ist wieder ein optisches Anzeigeelement 7 vorgesehen, das überhaupt eine Spannung zwischen den beiden Leitungskabeln 10 und 11 anzeigt, deren Polung für die Funktion der elektrischen Schaltung 5 richtig ist. Es ist auch wieder das akustische Anzeigeelement 8 vorgesehen, das mit einem Warnton auf auftretende Überspannungen aufmerksam macht. Daneben gibt es ein weiteres optisches Anzeigeelement 12. Dieses Anzeigeelement kann eine weitere Leuchtdiode sein, die durch ein einmaliges Auftreten von Überspannung eingeschaltet wird und eingeschaltet bleibt, bis sie beispielsweise durch Betätigung eines Rücksetzschalters 13 zurückgesetzt, d.h. wieder ausgeschaltet wird. Das Leuchten des Anzeigeelements 12 dokumentiert dann, dass mindestens einmal eine Überspannung aufgetreten ist. So können später auftretende Störungen in der Kraftfahrzeugelektrik eines der beiden Fahrzeuge dem Auftreten dieser Überspannung zugeordnet werden. Zur Unterscheidung von dem Anzeigeelement 7 kann das Anzeigeelement 12 ein optisches Signal mit einer anderen Wellenlänge abgeben. Gut geeignet ist beispielsweise eine grüne LED als optisches Anzeigeelement 7 und eine rote LED als optisches Anzeigeelement 12. Weiterhin weist die Vorrichtung 1 einen Umschalter 14 auf, um die Vorrichtung 1 an Nennspannungen von 12 bzw. 24 Volt anzupassen, so dass sie beispielsweise als Starthilfekabel sowohl für normale PKW (12 Volt) als auch für LKW (24 Volt) Verwendung finden kann.

### BEZUGSZEICHENLISTE

- 1 -: Vorrichtung
- 2 -: Anschlussklemme
- 3 -: Kontaktelement
- 4 -: Kabelabschnitt
- 5 -: Schaltung
- 6 -: Gehäuse
- 7 -: Anzeigeelement
- 8 -: Anzeigeelement
- 9 -: Angabe
- 10 -: Leitungskabel

- 11 -: Leitungskabel
- 12 -: Anzeigeelement
- 13 -: Rücksetzschalter
- 14 -: Umschalter

## Patentansprüche

1. Vorrichtung zum Schützen der elektrischen und elektronischen Bauteile eines Kraftfahrzeugs vor Überspannungen, mit zwei Kontaktelementen zur lösbaren Kontaktierung der beiden Pole einer Spannungsversorgung des Kraftfahrzeugs und mit einer zwischen die beiden Kontaktelemente geschalteten elektrischen Schaltung, wobei die elektrische Schaltung ein Anzeigeelement zum Anzeigen des Anliegens einer Spannung zwischen den beiden Kontaktelementen und ein Überspannungsschutzelement zum Abbauen von auftretenden und über einem Schwellwert liegenden Überspannungen aufweist, **dadurch gekennzeichnet, dass** die elektrische Schaltung (5) weiterhin ein Anzeigeelement (8, 12) zum Anzeigen von auftretenden und über einem Schwellwert liegenden Überspannungen aufweist.

2. Vorrichtung nach Anspruch 1, **dadurch gekennzeichnet, dass** das Anzeigeelement zum Anzeigen von auftretenden und über dem Schwellwert liegenden Überspannungen ein optisches und/oder akustisches Anzeigeelement (12 bzw. 8) ist.

3. Vorrichtung nach Anspruch 1 oder 2, derartig angepasst dass das Anzeigeelement (12) zum Anzeigen von auftretenden und über dem Schwellwert liegenden Überspannungen von einer Überspannung in einen Warnzustand überführt wird, in dem es auch nach dem Wiederabfallen der Spannung verbleibt, soweit es nicht zurückgesetzt wird.

4. Vorrichtung nach einem der Ansprüche 1 bis 3, derartig angepasst dass das Anzeigeelement zum Anzeigen von auftretenden und über einem Schwellwert liegenden Überspannungen die Höhe der aktuellen Überspannung anzeigt.

5. Vorrichtung nach einem der Ansprüche 1 bis 4, derartig angepasst , dass das Anzeigeelement zum Anzeigen von auftretenden und über einem Schwellwert liegenden Überspannungen die Höhe der höchsten aufgetretenen Überspannung anzeigt.

6. Vorrichtung nach einem der Ansprüche 1 bis 5, derartig angepasst, dass jedes Kontaktelement (3) einem der Pole der Spannungsversorgung des Kraftfahrzeugs zugeordnet ist, wobei das Anzeigeelement (7) zum Anzeigen des Anliegens einer Spannung zwischen den beiden Kontaktelementen (3) eine Spannung der richtigen Polung anzeigt.

7. Vorrichtung nach einem der Ansprüche 1 bis 6, **dadurch gekennzeichnet, dass** auf jeder Seite der elektrischen Schaltung zwei durch jeweils ein Leitungskabel (10 bzw. 11) miteinander verbundene Kontaktelemente (3) vorgesehen sind.

8. Vorrichtung nach einem der Ansprüche 1 bis 7, **dadurch gekennzeichnet, dass** der Schwellwert für die Überspannungen fest oder einstellbar ist und neben den Anzeigeelementen (7, 8, 12) angegeben ist.

## Claims

1. Device for protecting electric and electronic components of a motor vehicle from overvoltages, the device comprising two contact elements for non-permanently contacting the two electric poles of a voltage supply of the motor vehicle, and an electric circuit connected between the two contact elements, wherein the electric circuit comprises a signalling element for signalling the presence of a voltage between the two contact elements and an overvoltage protection element for reducing occurring overvoltages above a threshold value, **characterized in that** the electric circuit (5) further comprises a signalling element (8, 12) for signalling occurring overvoltages above a threshold value.

2. Device according to claim 1, **characterized in that** the signalling element for signalling occurring overvoltages above a threshold value is an optical or acoustic signalling element (12 or 8, resp.).

3. Device according to claim 1 or 2 adapted in such way that the signalling element (12) for signalling occurring overvoltages above the threshold value is transferred into a warning state by an overvoltage, in which it remains even after the voltage has dropped again, as long as it is not set back.

4. Device according to any of the claim 1 to 3, adapted in such way that the signalling element for signalling occurring overvoltages above a threshold value indicates the height of the present overvoltage.

5. Device according to any of claims 1 to 4, adapted in such way that the signalling element for signalling occurring overvoltages above a threshold value indicates the height of the highest overvoltage occurred.

6. Device according to any of the claims 1 to 5, adapted in such way that each contact element (3) is assigned to one of the electric poles of the voltage supply of the motor vehicle, wherein the signalling element (7) for signalling the presence of a voltage between the two contact elements (3) indicates a voltage of the correct polarity.

7. Device according to any of the claims 1 to 6, **characterized in that** two contact elements (3) connected by an electric cable (10 or 11 respectively) are provided on each side of the electric circuit.

8. Device according to any of the claims 1 to 7, **characterized in that** the threshold value for the overvoltages is fixed or adjustable and indicated adjacent to the signalling elements (7, 8, 12).

## Revendications

1. Dispositif de protection des composants électriques et électroniques d'une véhicule automobile contre les surtensions, avec deux éléments de contact pour la mise en contact amovible des deux pôles d'une alimentation en tension du véhicule et avec un circuit électrique monté entre les deux éléments de contact, le circuit électrique présentant un élément de signalisation pour signaler la présence d'une tension entre les deux éléments de contact et un élément de surtension pour réduire des surtensions apparaissant et situées au-dessus d'une valeur de seuil, **caractérisé en ce que** le circuit électrique (5) présente de plus un élément de signalisation (8, 12) pour afficher des surtensions qui surviennent et qui sont situées au-dessus d'une valeur de seuil.

2. Dispositif selon la revendication 1, **caractérisé en ce que** l'élément de signalisation pour afficher des surtensions qui surviennent et qui sont située au-dessus d'une valeur de seuil est un élément optique ou acoustique (12 ou 8).

3. Dispositif selon la revendication 1 ou 2, adapté de telle sorte que l'élément de signalisation (12) pour afficher des surtensions qui surviennent et qui sont située au-dessus d'une valeur de seuil est amené dans un état d'alarme dans lequel il reste même après la chute de la surtension tant qu'il n'est pas réinitialisé.

4. Dispositif selon l'une des revendications 1 à 3, adapté de telle sorte que l'élément de signalisation pour afficher des surtensions qui surviennent et qui sont située au-dessus d'une valeur de seuil, indique la hauteur de la surtension actuelle.

5. Dispositif selon l'une des revendications 1 à 4, adapté de telle sorte que l'élément de signalisation pour afficher des surtensions qui surviennent et qui sont située au-dessus d'une valeur de seuil, indique la hauteur de la surtension la plus élevée apparue.

6. Dispositif selon l'une des revendications 1 à 5, adapté de telle sorte que chaque élément de contact (3) est associé à l'un des pôles de l'alimentation en tension du véhicule, l'élément de signalisation (7), pour signaler la présence d'une tension entre les deux éléments de contact (3), indiquant une tension de polarité exacte.

7. Dispositif selon l'une des revendications 1 à 6, **caractérisé en ce que** deux éléments de contact (3) reliés entre eux avec chacun un câble conducteur (10 ou 11) sont prévus des deux côtés du circuit électrique.

8. Dispositif selon l'une des revendications 1 à 7, **caractérisé en ce que** la valeur de seuil pour les surtensions est fixe ou réglable et est indiquée à côté des éléments de signalisation (7, 8, 12).
